(19) Europäisches Patentamt / European Patent Office / Office européen des brevets

(11) **EP 3 235 149 B1**

(12) **FASCICULE DE BREVET EUROPEEN**

(45) Date de publication et mention
de la délivrance du brevet:
**30.01.2019  Bulletin 2019/05**

(51) Int Cl.:
*H04B 10/90* *(2013.01)*  *G02F 1/35* *(2006.01)*
*G02F 2/00* *(2006.01)*

(21) Numéro de dépôt: **15808571.2**

(22) Date de dépôt: **11.12.2015**

(86) Numéro de dépôt international:
**PCT/EP2015/079354**

(87) Numéro de publication internationale:
**WO 2016/096633 (23.06.2016 Gazette 2016/25)**

(54) **COMPOSANT OPTOELECTRONIQUE POUR GENERER ET RAYONNER UN SIGNAL HYPERFREQUENCE**

OPTOELEKTRONISCHES BAUELEMENT ZUR ERZEUGUNG UND AUSSENDUNG EINES HOCHFREQUENZSIGNALS

OPTOELECTRONIC COMPONENT FOR GENERATING AND RADIATING A HYPERFREQUENCY SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **17.12.2014  FR 1402880**

(43) Date de publication de la demande:
**25.10.2017  Bulletin 2017/43**

(73) Titulaires:
• **Thales**
  **92400 Courbevoie (FR)**
• **Alcatel Lucent**
  **91620 Nozay (FR)**

(72) Inventeur: **VAN DIJK, Frédéric**
  **91120 Palaiseau (FR)**

(74) Mandataire: **Joubert, Cécile et al
Marks & Clerk France
Counseils en Propriete Industrielle
Immeuble "Visium"
22, avenue Aristide Briand
94117 Arcueil Cedex (FR)**

(56) Documents cités:
**EP-A1- 1 774 627     US-A1- 2012 147 907**

• STOEHR A ET AL: "OPTICAL HETERODYNE MILLIMETER-WAVE GENERATION USING 1.55-MUM TRAVELING-WAVE PHOTODETECTORS", IEEE TRANSACTIONS ON MICROWAVE THEORY AND TECHNIQUES, IEEE SERVICE CENTER, PISCATAWAY, NJ, US, vol. 49, no. 10, 1 octobre 2001 (2001-10-01), pages 1926-1933, XP001108245, ISSN: 0018-9480, DOI: 10.1109/22.954809

• VAN DIJK FREDERIC ET AL: "Integrated InP Heterodyne Millimeter Wave Transmitter", IEEE PHOTONICS TECHNOLOGY LETTERS, IEEE SERVICE CENTER, PISCATAWAY, NJ, US, vol. 26, no. 10, 1 mai 2014 (2014-05-01), pages 965-968, XP011546254, ISSN: 1041-1135, DOI: 10.1109/LPT.2014.2309353 [extrait le 2014-04-21]

• E. ROUVALIS ET AL: "High-speed photodiodes for InP-based photonic integrated circuits", OPTICS EXPRESS, vol. 20, no. 8, 9 avril 2012 (2012-04-09), page 9172, XP055081154, ISSN: 1094-4087, DOI: 10.1364/OE.20.009172

• DEMIGUEL S ET AL: "Very high-responsivity evanescently coupled photodiodes integrating a short planar multimode waveguide for high-speed applications", IEEE PHOTONICS TECHNOLOGY LETTERS, IEEE SERVICE CENTER, PISCATAWAY, NJ, US, vol. 15, no. 12, 1 décembre 2003 (2003-12-01), pages 1761-1763, XP011427256, ISSN: 1041-1135, DOI: 10.1109/LPT.2003.819724

- **BELING ANDREAS ET AL: "High-Speed Photodiodes", IEEE JOURNAL OF SELECTED TOPICS IN QUANTUM ELECTRONICS, IEEE SERVICE CENTER, PISCATAWAY, NJ, US, vol. 20, no. 6, 1 novembre 2014 (2014-11-01), pages 1-7, XP011557847, ISSN: 1077-260X, DOI: 10.1109/JSTQE.2014.2341573 [extrait le 2014-09-01]**

**Description**

DOMAINE DE L'INVENTION

L'invention concerne les composants optoélectroniques, et plus particulièrement les composants intégrés ayant pour fonction de générer et de rayonner un signal électromagnétique présentant une fréquence comprise entre 30 GHz et 10 THz dénommée fréquence hyper dans la suite du document, à partir d'ondes optiques présentant une longueur d'onde entre 400 nm et 10 $\mu$m.

ETAT DE LA TECHNIQUE

La génération de signaux hyperfréquence de type ondes millimétriques (onde radio RF de fréquence entre 30 GHz et 300 GHz) et de type TéraHertz (fréquence entre 100 GHz et 10 THz) présente de nombreuses applications dans les domaines de la détection, de la spectroscopie et de la transmission sans fil de données haut débit. Dans ce dernier domaine, plus la fréquence de support est élevée, plus le débit qui peut être transporté est important. A titre d'exemple, pour une porteuse à 1 GHz, un débit maximum de 1 Gbit/s est obtenu, alors qu'avec une porteuse de 1 THz, des débits de 10 à 20 Gbit/s sont possibles, d'où l'intérêt de développer des composants capables d'émettre dans cette gamme de fréquences avec une puissance suffisante.

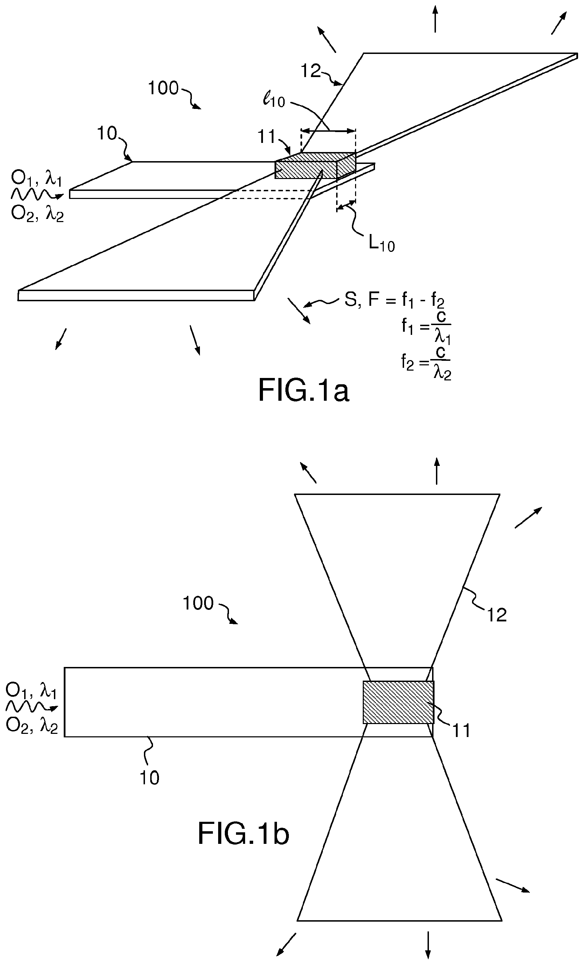

Une première solution selon l'état de la technique est un composant 100 apte à émettre un signal S de fréquence hyper F illustré figure 1 (figure 1a vue en perspective et figure 1b vue de dessus). Cette photodiode unitaire 100 comprend un guide planaire 10 dans lequel se propagent deux ondes optiques, une onde O1 de longueur d'onde $\lambda$1 et une onde O2 de longueur d'onde $\lambda$2, et un photo-mélangeur 11 associé de faible taille. $\lambda$1 et $\lambda$2 sont telles qu'elles présentent un battement hétérodyne, c'est-à-dire que le module de la différence f1 - f2 des fréquences optiques associées f1 et f2 est égal à une fréquence F dans le domaine hyper :

$$f1 = C/\lambda 1$$

$$f2 = C/\lambda 2$$

F = |f1-f2| de l'ordre du TeraHz.
Les ondes optiques sont couplées au photo-mélangeur 11 par couplage évanescent de manière à ce que celui-ci génère une onde à la fréquence F. La photodiode 100 comprend également une antenne 12 en métal, présentant une forme en noeud de papillon, couplée au photo-mélangeur 11, et qui rayonne dans l'espace un signal électromagnétique S de fréquence F. La longueur $l_{10}$ de photo-mélangeur est typiquement de 10 à 20 $\mu$m car il faut limiter la capacité parasite que présenterait le dispositif et qui atténuerait fortement le signal à la fréquence F détecté. De plus, un allongement ne permettrait pas d'augmenter la puissance absorbée, la majeure partie de la lumière étant absorbée dans les 10 premiers microns du composant.
La largeur $L_{10}$ est dimensionnée pour être de l'ordre de grandeur des longueurs d'onde optique, typiquement 2 à 3 fois supérieure, mais pas plus. En effet, $L_{10}$ doit rester suffisamment faible pour que le composant fonctionne correctement au delà de 30 GHz. Lorsque $L_{10}$ devient trop grande, le transport du signal à l'interface semi-conducteur (photo-mélangeur 11) / métal (antenne 12) est dégradé par la présence de capacités parasites (effets capacitifs et effets temps de transit) qui ont pour effet d'atténuer le signal S de fréquence F photogénéré.
La limitation en dimension de $L_{10}$ a pour inconvénient de limiter la puissance qui peut être rayonnée.
De plus, la faible dimension du composant 100 impose l'utilisation d'une antenne 12 pour s'adapter à la taille du mode RF du signal S.

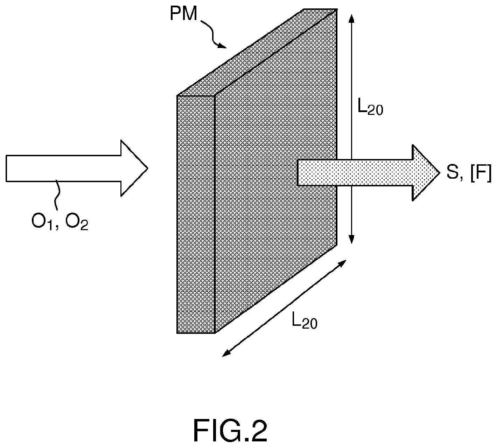

Une deuxième solution selon l'état de la technique est un système 200 apte à émettre un signal S de fréquence hyper F, basé sur une intégration de photodiodes planaires arrangées en matrice 2D ou d'un émetteur de grande surface sous la forme d'une photodiode de grande taille, tel qu'illustré figure 2. Les ondes optiques O1 et O2 sont directement incidentes sur un côté du composant PM qui rayonne le signal de fréquence F du côté opposé.

Cette solution présente une faible efficacité de couplage parce que le photo-mélangeur PM est constitué par une couche de faible épaisseur, ce qui limite l'interaction entre la lumière et le photo-mélangeur. De plus, pour polariser chaque photo-mélangeur de la matrice il faut réaliser des électrodes opaques qui réduisent la surface d'interaction entre la lumière et les photo-mélangeurs.
Sa mise en oeuvre avec des éléments optiques discrets pour mettre en forme les signaux O1 et O2 rend le système 200 volumineux. De plus, ce système ne permet pas d'intégrer sur la même plaque d'autres fonctions interagissant avec la lumière comme l'amplification, la modulation d'amplitude ou de phase. En outre les matrices 2D ne permettent pas de localiser l'éclairement dans les zones où la photo-détection est désirée de manière efficace, ce qui limite le rendement puissance haute fréquence générée / puissance optique incidente.

Lorsque l'on cherche à introduire un balayage d'une onde radio dans la gamme millimétrique, les solutions actuelles présentent plusieurs inconvénients. Une solution à base de composants optiques discrets est volumineuse et le signal émis présente une forte divergence. Une solution alternative à base d'éléments mécaniques est également volumineuse, et comprend un élément mobile qui n'est pas compatible avec tous les systèmes.

La publication 'Optical heterodyne millimeter-wave genenration using 1.55 $\mu$m travelig-wave photodetectors", Stoehr et al, IEE Transactions on microwave theory and techniques, vol 49, n°10 (2001) page 1926-1933, porte sur un composant optoélectronique pour rayonner un signal présentant une fréquence hyper.

Le document « High speed photodiodes for InP-based photonic integrated circuits » de Rouvalis et al, Optic Express, vol 20, n° 8 (2012) page 9170, décrit des photodiodes à couplage évanescent émettant dans la bande 90-140 GHz.

Un but de la présente invention est de pallier les inconvénients précités et plus particulièrement de réaliser un composant optoélectronique intégré apte à générer et rayonner un signal hyper (également dénommé signal haute fréquence) sans antenne.

DESCRIPTION DE L'INVENTION

La présente invention a pour objet un composant optoélectronique pour générer et rayonner un signal électromagnétique présentant une fréquence comprise entre 30 GHz et 10 THz dénommée fréquence hyper, comprenant :

- un guide planaire configuré pour confiner et propager librement dans un plan XY une première et une deuxième ondes optiques présentant une différence de fréquence optique, dénommée battement hétérodyne, égale à ladite fréquence hyper,
- un système d'injection desdites ondes optiques dans ledit guide planaire,
- un photo-mélangeur couplé audit guide planaire de manière à générer, à partir de la première onde optique et de la deuxième onde optique, un signal présentant ladite fréquence hyper,
  ledit photo-mélangeur ayant une forme allongée présentant selon un axe Y une grande dimension supérieure ou égale à la demi longueur d'onde du signal,
- ledit système d'injection étant configuré de sorte que lesdites ondes optiques se recouvrent dans ledit guide planaire et se couplent au photo-mélangeur sur une longueur selon l'axe Y au moins égale à la demi longueur d'onde dudit signal, le photo-mélangeur étant ainsi apte à rayonner ledit signal (S).

Avantageusement, ledit guide planaire comprend une couche de propagation entre deux couches de confinement.

Avantageusement, le photo-mélangeur est déposé sur une couche de confinement et le couplage s'effectue par ondes évanescentes.

Selon un mode de réalisation, le guide planaire est configuré pour confiner des ondes optiques présentant chacune une longueur d'onde proche de 1.5 $\mu$m.

Selon une variante, le guide planaire comprend une partie amplificatrice apte à amplifier lesdites première et deuxième ondes optiques.

Selon une variante, le système d'injection est configuré pour que les ondes optiques injectées présentent une forte divergence.

Avantageusement ledit système d'injection comprend au moins un guide dit monodimensionnel configuré pour confiner les ondes optiques de manière à ce que lesdites ondes se propagent selon leurs directions de propagation respectives.

Préférentiellement, le guide monodimensionnel est constitué d'un prolongement du guide planaire comprenant une couche de confinement en forme de ruban.

Selon un mode de réalisation le système d'injection comprend au moins une fibre optique.

Selon un mode de réalisation le système d'injection comprend un dispositif d'injection unique . Préférentiellement ledit dispositif d'injection unique est configuré pour injecter les première et deuxième ondes optiques de manière à ce que lesdites ondes se propagent selon une direction de propagation sensiblement égale à une direction X perpendiculaire à l'axe Y.

Selon un autre mode de réalisation, ledit système d'injection comprend un premier dispositif d'injection configuré pour injecter la première onde optique de manière à ce que ladite première onde se propage selon une première direction de propagation comprise dans le plan XY, et un deuxième dispositif d'injection configuré pour injecter la deuxième onde optique de manière à ce que ladite deuxième onde se propage selon une deuxième direction de propagation comprise dans le plan XY différente de la première direction de propagation.

Avantageusement un seul desdits premier et deuxième dispositifs d'injections présente une direction de propagation perpendiculaire audit axe Y.

Selon un mode de réalisation le guide planaire comprend en outre au moins un déflecteur situé sur le chemin optique d'une des ondes optiques configuré pour défléchir ladite onde optique de manière à la dévier d'un angle de déviation optique choisi, moyennant quoi le signal rayonné par ledit photo-mélangeur est apte à être dévié selon un angle de déviation fonction dudit angle de déviation optique.

Préférentiellement le déflecteur est un modulateur électro-optique configuré pour modifier l'indice de réfraction d'une portion de la couche de propagation, ladite portion présentant une forme prismatique dans le plan XY.

Selon un mode de réalisation ledit déflecteur est un modulateur de phase comprenant une pluralité de déphaseurs discrets commandés indépendamment.

Préférentiellement, chaque déphaseur discret est un modulateur électro-optique configuré pour modifier l'indice de réfraction d'une portion de la couche de propagation (Cp).

D'autres caractéristiques, buts et avantages de la présente invention apparaîtront à la lecture de la description détaillée qui va suivre et en regard des dessins annexés donnés à titre d'exemples non limitatifs et sur lesquels :

- La figure 1 déjà citée illustre un composant unitaire pour générer un signal hyper selon l'état de la technique, la figure 1a illustre une vue en perspective et la figure 1b illustre une vue de dessus.
- La figure 2 déjà citée illustre un système 2D pour générer un signal hyper selon l'état de la technique,
- La figure 3 illustre un composant optoélectronique selon l'invention, la figure 3a illustre une vue de dessus et la figure 3b illustre une vue de profil,
- La figure 4 décrit un exemple de guide planaire,
- La figure 5 décrit une première variante du composant selon l'invention intégrant une fonction d'amplification,
- La figure 6 illustre un exemple de guide planaire du composant selon l'invention avec amplificateur intégré,
- La figure 7 illustre un premier mode de réalisation du système d'injection du composant selon l'invention comprenant un dispositif d'injection unique, la figure 7a illustre une vue de dessus et la figure 7b illustre une vue de profil,
- La figure 8 illustre un dispositif d'injection unique obtenu par prolongement du guide planaire vu en coupe,
- La figure 9 illustre un deuxième mode de réalisation du système d'injection du composant selon l'invention comprenant deux dispositifs d'injection, un pour chaque onde optique, la figure 9a illustre une vue de dessus et la figure 9b illustre une vue de profil,
- La figure 10 illustre un mode préféré du composant selon l'invention dans lequel un dispositif d'injection d'une onde optique est tel que l'onde optique se propage perpendiculairement à l'axe y
  La figure 11 illustre le principe de déviation d'une onde optique dans le guide planaire,
- La figure 12 illustre un composant selon l'invention selon le mode préféré et apte à défléchir l'onde hyperfréquence,
- La figure 13a illustre un exemple de déphaseur continu vu de dessus et la figure 13b illustre ce déphaseur vu en coupe,
- La figure 14 illustre un modulateur de phase comprenant une pluralité de déphaseurs discrets,
- La figure 15 illustre un exemple de déphaseur électro-optique discret,
- La figure 16 illustre un composant selon l'invention selon le mode préféré apte à défléchir l'onde hyperfréquence à l'aide d'un modulateur de phase.

DESCRIPTION DETAILLEE DE L'INVENTION

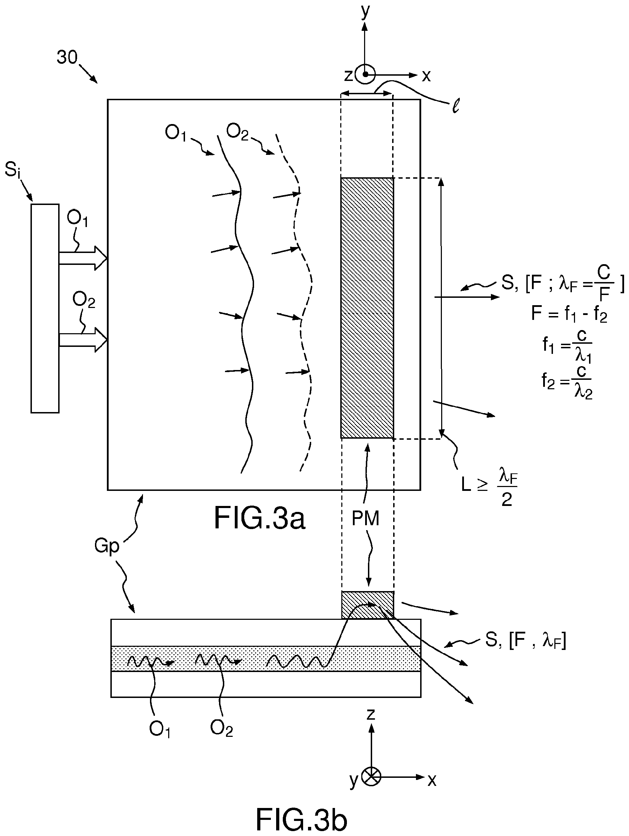

La figure 3 illustre un composant optoélectronique 30 selon l'invention. La figure 3a illustre une vue de dessus et la figure 3b illustre une vue de profil.

Ce composant est apte à générer et rayonner un signal électromagnétique S présentant une fréquence F comprise entre 30 GHz et 10 THz dénommée fréquence hyper. Préférentiellement la fréquence hyper émise est comprise entre 100 GHz et 2 THz.

Cette plage de fréquence recouvre les fréquences RF millimétriques et les fréquences THz.

Le composant 30 comprend un guide planaire Gp configuré pour confiner et propager librement dans un plan XY une première onde optique O1 de longueur d'onde $\lambda 1$ et de fréquence optique f1 =C/$\lambda 1$ et une deuxième onde optique O2 de longueur d'onde $\lambda 2$ et de fréquence optique f2 =C/$\lambda 2$, ces deux ondes présentant une différence de fréquence optique f1-f2 dénommée battement hétérodyne, égale à une fréquence hyper F.

$$I\,f1\text{-}f2\,I = F$$

Les ondes optiques présentent typiquement une longueur d'onde comprise entre 400 nm et 10 $\mu$m, et préférentiellement entre 1.2 $\mu$m et 7 $\mu$m.

Les longueurs d'onde λ1 et λ2 sont très proches. Par exemple pour F = 1THz et λ1= 1.50 $\mu$m, on a λ2= 1.508 $\mu$m.

Le composant 30 comprend également un système d'injection Si des ondes optiques O1, O2 dans le guide planaire Gp. Différentes configurations d'injection compatibles avec l'invention sont décrites plus loin.

Enfin, le composant 30 comprend également un photo-mélangeur PM couplé au guide planaire Gp de manière à générer, à partir de la première onde optique O1 et de la deuxième onde optique O2, un signal S présentant la fréquence hyper F.

Le photo-mélangeur PM selon l'invention a une forme allongée présentant selon un axe Y une grande dimension L supérieure ou égale à $\lambda_F/2$, avec $\lambda_F$ longueur d'onde du signal S de fréquence F :

$$L \geq \lambda_F /2 \text{ avec } \lambda_F = C/F$$

De plus, le système d'injection Si est configuré de sorte que les ondes optiques O1 et O2 se recouvrent dans le guide planaire Gp et se couplent au photo-mélangeur PM sur une longueur selon l'axe Y au moins égale à la demi longueur d'onde $\lambda_F$ du signal S.

La divergence d'un faisceau, si on fait l'hypothèse qu'il est de type gaussien, se fait avec un angle total qui sera de 150° si la dimension de l'élément rayonnant est de $\lambda_F /2$. Si la dimension de l'élément rayonnant est encore plus petite, la directivité de l'émetteur sera très dégradée et le faisceau émis ne pourra pas être utilisé efficacement. Ainsi, un rayonnement à la fréquence F avec une divergence acceptable nécessite un élément rayonnant d'une dimension au moins égale à $\lambda_F/2$.

Le recouvrement des ondes sur une distance d'au moins $\lambda_F/2$ au niveau du photo-mélangeur PM et la forme allongée selon Y de celui-ci le rendent ainsi apte à rayonner le signal S dans l'espace selon une direction de propagation X sensiblement perpendiculaire à Y, sans nécessité d'une antenne additionnelle. Le photo-mélangeur allongé PM reçoit de la lumière qui se propage dans le guide planaire Gp d'un côté et réémet le signal S issu du photo-mélange de l'autre côté.

La grande dimension L du photo-mélangeur PM permet un rayonnement peu divergent dans le plan XY. De plus, l'augmentation de la taille du PM par rapport à celle du photo-mélangeur d'une photodiode unitaire telle que décrite figure 1, permet également de répartir la puissance sur toute la dimension L et ainsi d'augmenter la puissance optique que l'on peut coupler sans destruction, conduisant à rayonner un signal S plus puissant.

La petite dimension $\ell$ est par exemple du même ordre de grandeur que la dimension $l_{10}$ de la photodiode unitaire de la figure 1.

Le signal rayonné par le photo-mélange présente une fréquence F comprise dans une gamme de fréquence [30 GHZ, 10 THz], préférentiellement [100 GHz, 2THz]. Par exemple, les longueurs d'onde $\lambda_F$ correspondantes pour cette dernière bande sont comprises entre 40 $\mu$m et 900 $\mu$m, dans un matériau photo-mélangeur en GaAs ou en GaInAsP.

Le fait que le couplage des ondes optiques au photo-mélangeur allongé PM soit réalisé par un guide planaire Gp confère au composant 30 une structure intégrée à fort rendement, le rendant peu encombrant, et permettant l'adjonction dans le guide planaire Gp de fonctions additionnelles décrites plus loin permettant un traitement de la lumière se propageant dans le composant.

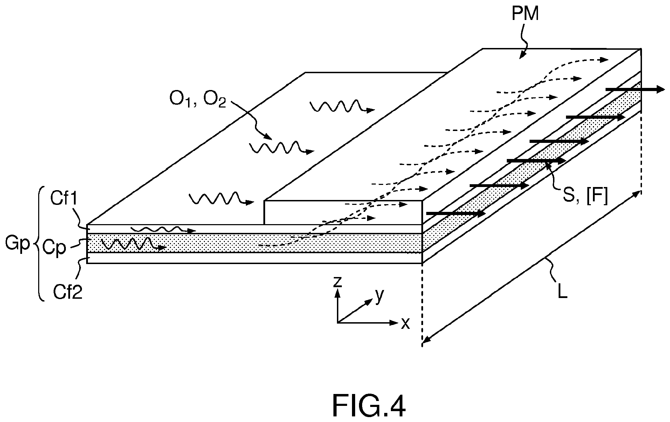

Préférentiellement le guide planaire Gp comprend une couche de propagation Cp entre deux couches de confinement Cf1, Cf2 tel qu'illustré figure 4.

A titre d'exemple illustratif, le guide planaire Gp est configuré pour confiner des ondes optiques présentant chacune une longueur d'onde proche de 1.5 $\mu$m, qui est obtenue à l'aide de sources DFB ou DBR à base de GaInAsP sur InP bien connues.

La couche de propagation Cp comprend une couche de GaInAsP et chaque couche de confinement Cf1, Cf2 comprend une couche d'InP.

Préférentiellement, le photo-mélangeur PM est déposé sur une couche de confinement et le couplage s'effectue par ondes évanescentes.

Selon une autre variante, le couplage est de type « bout-à-bout », le photo-mélangeur PM étant placé directement en face de la couche de propagation. Pour l'exemple illustratif précédent, typiquement le photo-mélangeur comprend du GaInAsP.

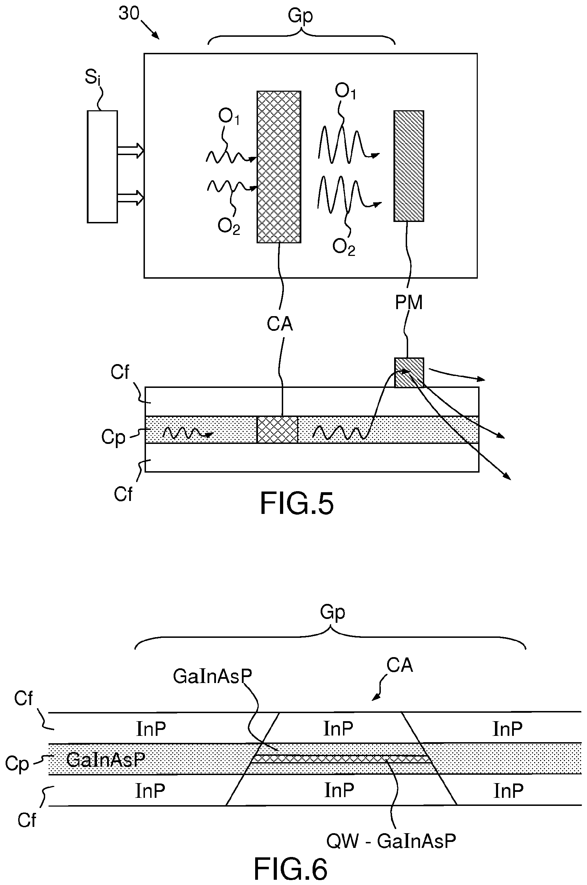

Selon une première variante le caractère intégré de la structure du composant 30 permet l'adjonction d'une fonction d'amplification à l'intérieur du guide planaire, comme illustré figure 5 (la figure 5a représente la vue de dessus et la figure 5b représente la vue de profil). Par exemple le guide planaire Gp comprend une partie amplificatrice CA apte à amplifier les ondes optiques O1 et O2 réalisée dans la couche de propagation Cp. Ainsi la puissance optique disponible est augmentée par la partie amplificatrice CA, ce qui permet au composant 30 de générer et rayonner un signal S présentant une puissance hyper également augmentée.

Pour l'exemple illustratif précédent, la couche amplificatrice CA comprend préférentiellement une couche en GaInAsP comprenant des puits quantiques QW en GaInAsP, tel qu'illustré figure 6.

Il peut y avoir un seul ou plusieurs puits quantiques. Ils sont constitués de barrières en GaInAsP et de puits également en GaInAsP. La composition des barrières et des puits diffère de manière à créer un puits de potentiel permettant la génération de lumière quand un courant est appliqué.

Nous allons donner à présent des exemples non limitatifs de configurations du système d'injection Si.

Afin de générer des ondes optiques O1 et O2 qui présentent au niveau du photo-mélangeur PM une dimension suffisante, une variante est que le système d'injection Si soit configuré pour que les ondes optiques injectées présentent une forte divergence.

Par exemple, des faisceaux concentrés formant deux pseudo sources de très faible dimension, quasi ponctuelles, sont couplés dans Gp.

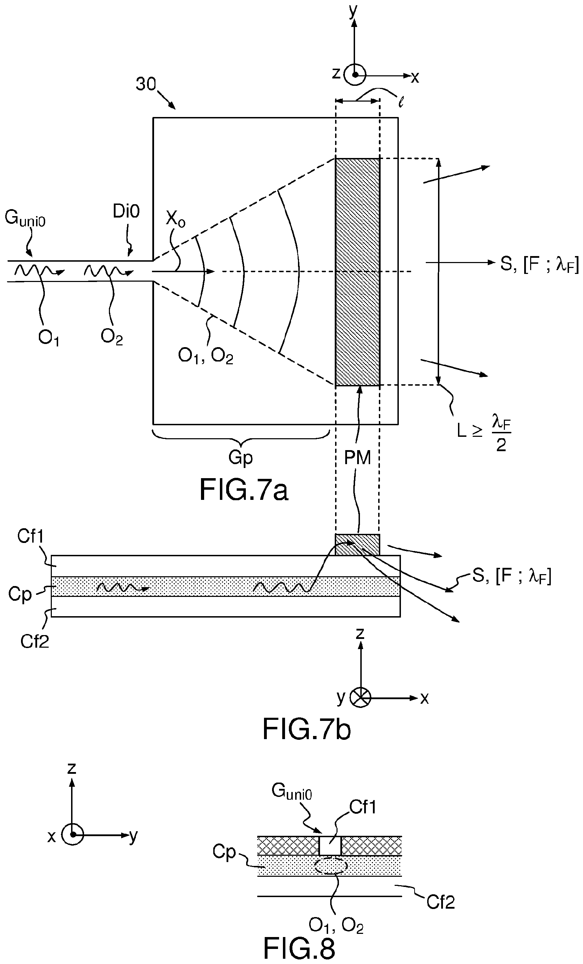

Selon un premier mode de réalisation illustré figure 7 le système d'injection Si comprend un dispositif d'injection unique Di0 commun aux deux ondes O1 et O2. La figure 7a représente la vue de dessus et la figure 7b représente la vue de profil. Les ondes O1 et O2 sont alors colinéaires, ce qui garantit un recouvrement optimum et aboutit à un composant simplifié.

Préférentiellement le dispositif d'injection unique Di0 est configuré pour injecter les ondes optiques O1, O2 de manière à ce qu'elles se propagent dans le guide planaire selon une direction de propagation sensiblement égale à une direction X perpendiculaire à l'axe Y. Cette configuration est relativement simple car elle nécessite la mise en oeuvre d'un seul couplage optique pour injecter O1 et O2.

Une première variante pour obtenir des ondes O1 et O2 à forte divergence dans Gp, également illustrée figure 7, est que le dispositif d'injection Di0 comprend un guide dit monodimensionnel GuniO configuré pour confiner les ondes optiques O1, O2 de manière à ce que ces ondes se propagent selon leur direction de propagation commune X0 comprise dans le plan XY. Chaque onde confinée dans le guide monodimensionnel va voir sa divergence augmenter fortement lorsqu'elle pénètre dans le guide planaire, du fait de l'élargissement de la zone de propagation. Chaque onde se propage ainsi « librement » dans le plan XY autour d'une direction X0 égale à la direction du guide monodimensionnel.

Une configuration optimale est un guide Guni perpendiculaire à Y et selon un axe X0 passant par le milieu de PM.

Préférentiellement le guide monodimensionnel GuniO est constitué d'un prolongement du guide planaire Gp du côté de l'arrivée de la lumière et comprend une couche de confinement en forme de ruban. Les ondes optiques se propageant dans la couche de propagation Cp sont alors confinées selon la direction du ruban, comme illustré figure 8.

Le guide GuniO peut être obtenu en supprimant localement le matériau utilisé pour former Cf1, de manière à former un ruban selon l'axe x. Sachant que l'indice de réfraction du matériau utilisé pour Cp est supérieur aux indices de réfraction du matériau utilisé pour Cf1 et Cf2, les ondes optiques O1 et O2 sont confinées selon l'axe y pour former un guide d'onde monomode.

Une deuxième variante pour obtenir des ondes O1 et O2 à forte divergence dans Gp est un dispositif d'injection Di0 comprenant une fibre unique se terminant par une pointe couplée au guide planaire Gp.

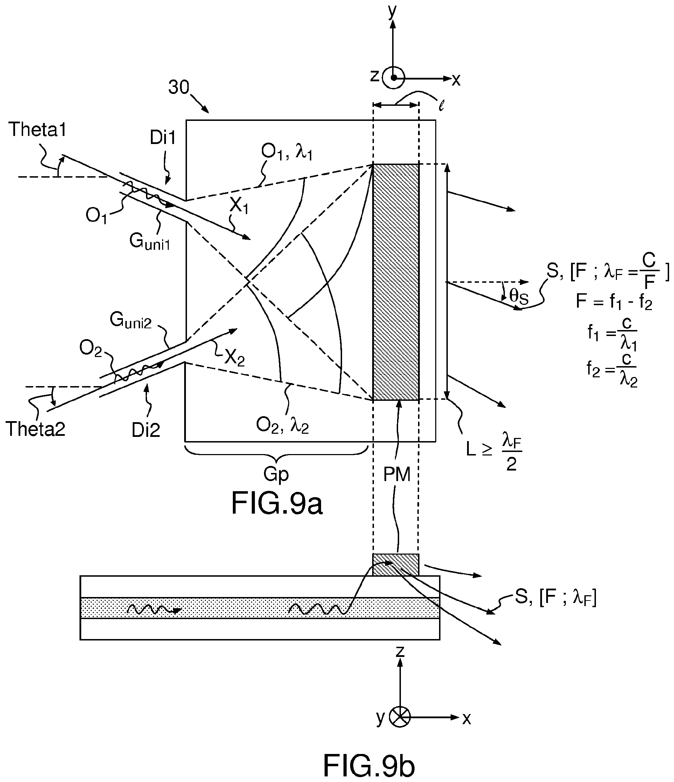

Selon un deuxième mode de réalisation illustré figure 9 le système d'injection Si comprend un premier dispositif d'injection Di1 configuré pour injecter la première onde optique O1 de manière à ce qu'elle se propage selon une première direction de propagation X1 comprise dans le plan XY, et un deuxième dispositif d'injection Di2 configuré pour injecter la deuxième onde optique O2 de manière à ce qu'elle se propage selon une deuxième direction de propagation X2 comprise dans le plan XY et différente de la première direction de propagation X1. La figure 9a représente la vue de dessus et la figure 9b représente la vue de profil.

La direction X1 présente un angle de theta1 par rapport à l'axe x. La direction X2 présente un angle theta2 par rapport à l'axe x.

Le signal S est alors généré selon un angle $\theta s$ correspondant à l'angle entre la direction de propagation Xs du signal S et l'axe x dans le plan xy.

Dans cette configuration $\theta s$ se déduit de la relation suivante :

$$\theta s = \sin^{-1}\{ \lambda_F *[(\sin(theta1)/ \lambda_1)+(\sin(theta2)/ \lambda_2)] \}$$

Cette configuration permet de traiter indépendamment les deux ondes O1 et O2, qui ne sont plus colinéaires dans ce cas. Les axes de propagation X1 et X2 et la divergence des ondes optiques sont configurés pour que les ondes O1 et O2 se recouvrent sur une dimension supérieure ou égale à $\lambda_F/2$ au niveau du photo-mélangeur PM.

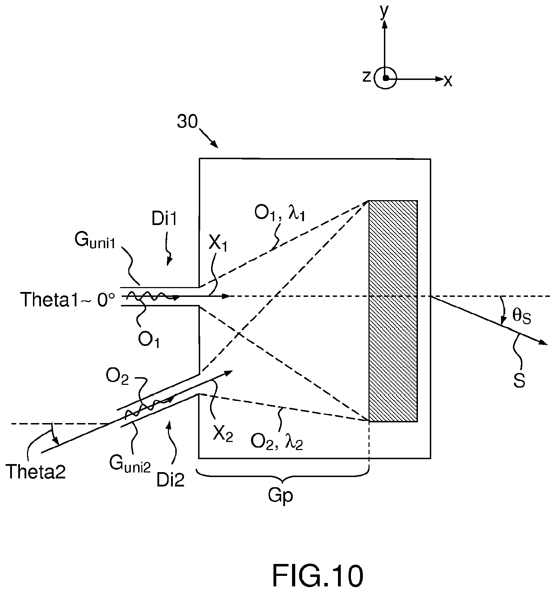

Selon un mode préféré tel qu'illustré figure 10 un seul des dispositifs, par exemple le premier dispositif D i1, est disposé de manière à ce que l'onde O1 suive une direction de propagation X1 sensiblement perpendiculaire à l'axe y (theta1 ~ 0°) et le deuxième dispositif d'injection Di2 est disposé de manière à ce que l'onde O2 suive une direction X2.

Dans cette configuration $\theta s$ se déduit de la relation suivante :

7

$$\Theta s = \sin^{-1}\{ [\lambda_F/\lambda_2]*\sin(theta2)\}$$

Par exemple, pour un signal S à 1 THz, qui a une longueur d'onde $\lambda_F$=C/F=300$\mu$m avec un signal optique O2 à une longueur d'onde $\lambda_2$ de 1.5$\mu$m avec un angle theta1 =0° et theta2=0.2°, l'angle $\theta$s vaut 44°.

On constate qu'une très faible différence theta1-theta2 engendre une déviation importante du signal hyperfréquence.

Pour la variante à guide monodimensionnel, chaque dispositif d'injection Di1 et Di2 comprend respectivement un guide Guni1, Guni2 orientés selon les directions X1, X2. L'onde O1 est injectée via Guni1 et l'onde O2 est injectée via Guni2.

Pour la variante avec des fibres optiques, le premier dispositif d'injection Di1 comprend une première fibre optique et le deuxième dispositif d'injection Di2 comprend une deuxième fibre optique. L'onde O1 est injectée via la première fibre et l'onde O2 est injectée via la deuxième fibre.

Selon une deuxième variante le caractère intégré de la structure du composant 30 permet l'adjonction d'une fonction de déviation d'au moins une onde optique par déphasage spatial.

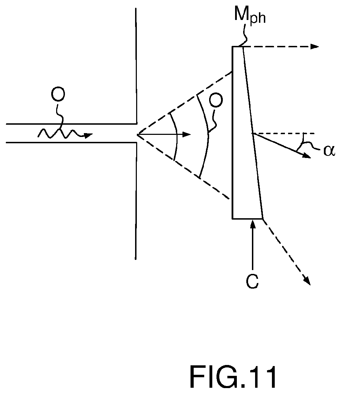

Le principe de la déviation d'une onde O à forte divergence se propageant dans un guide planaire par déphasage est illustré figure 11. Le déflecteur Mph est configuré pour faire varier le déphasage optique spatialement, continûment ou discrètement de manière à opérer une déviation d'un angle $\alpha$ choisi de la direction de propagation de l'onde O, selon un principe connu. Le déflecteur est par exemple commandé à l'aide d'une commande électrique C.

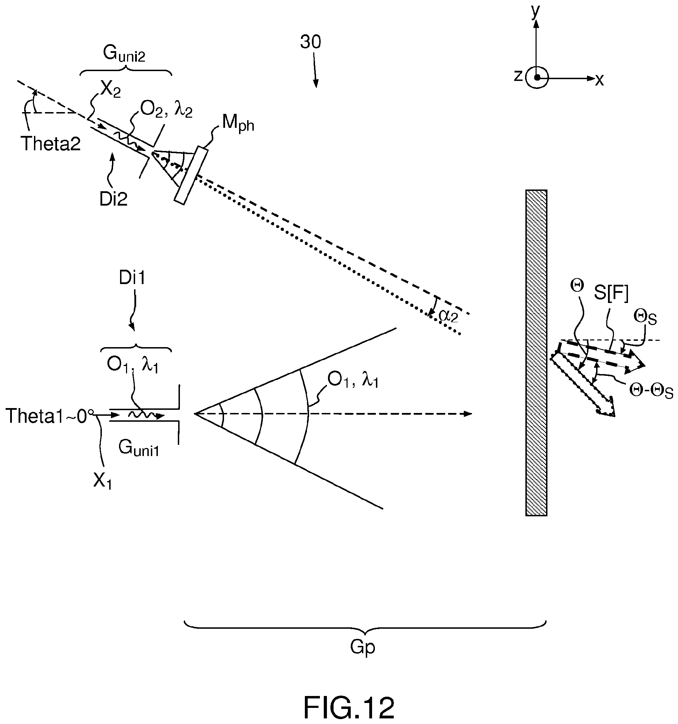

Cette fonction est appliquée au composant 30 selon l'invention tel qu'illustré figure 12 dans la configuration préférée illustrée figure 10.

Dans ce mode de réalisation, le guide planaire Gp du composant 30 selon l'invention comprend en outre un déflecteur $M_{Ph}$ situé par exemple sur le chemin optique de l'onde optique O2 présentant une direction de propagation selon un angle theta2 non nul, et configuré pour défléchir la deuxième onde optique O2 de manière à la dévier par rapport à la direction de propagation theta2 initiale d'un angle $\alpha$2 de déviation optique choisi.

Au niveau du photo-mélangeur PM, cette variation de direction de propagation $\alpha$2 se répercute au niveau du rayonnement du signal hyper S, dont la direction de rayonnement Xs faisant un angle $\theta$s (c'est-à-dire la direction de pointage correspondant du maximum d'énergie rayonnée) est également déviée d'un angle de déviation $\theta$-$\theta$s fonction de l'angle de déviation optique $\alpha$2. Dans cette configuration l'angle $\theta$ que fait l'onde hyperfréquence avec l'axe x se déduit de la relation suivante :

$$\Theta = \sin^{-1}\{ \lambda_F *[ (\sin(theta2+ \alpha2)/ \lambda_2) \}$$

Ainsi l'onde hyperfréquence S présente au départ un angle $\theta$s, qui est modifié en un angle $\theta$

Par exemple pour un signal S à 1 THz, qui a une longueur d'onde $\lambda_F$=C/F=300$\mu$m, obtenu avec une signal optique O2 à une longueur d'onde $\lambda_2$ de 1.5$\mu$m avec un angle theta1 =0° et theta2=0.2°, l'angle $\theta$s vaudra 44°.

Pour une déflection du signal O2 de 0.05 réalisée avec le déflecteur $M_{Ph,}$ l'angle $\theta$ est de 61°. Le signal S est ainsi défléchi de 17°.

Le signal S dévié conserve la faible divergence dans le plan XY dûe à la géométrie allongée du photo-mélangeur. Avec un déflecteur commandable permettant de modifier la valeur de $\alpha$2, il est possible de réaliser un balayage angulaire du signal S.

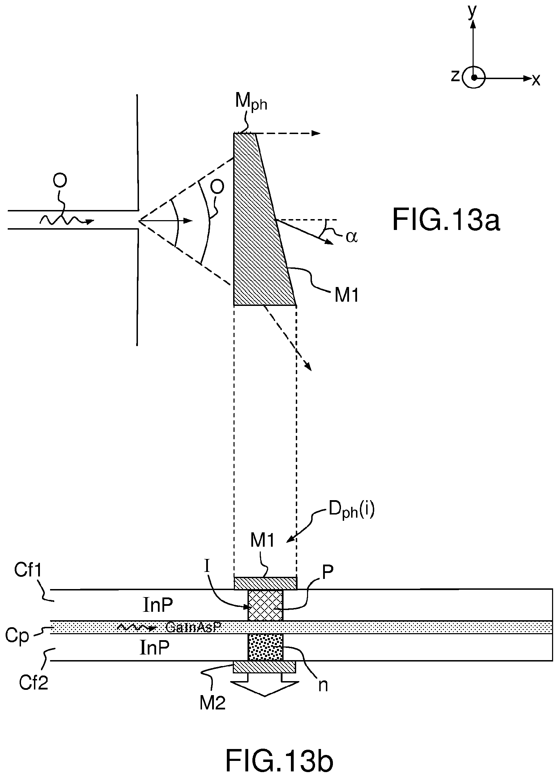

Un exemple de déflecteur électro-optique $M_{ph}$ est illustré figure 13a (vue de dessus) et figure 13b (vue en coupe) pour un guide planaire comprenant une couche de propagation Cp en GaInAsP et deux couches de confinements Cf1 Cf2 en InP.

Une couche métallique M1 disposée sur la couche Cf1 délimite $M_{ph}$. Une zone de la couche Cf1 sous la couche métallique M est dopée p tandis que la zone de la couche Cf2 de l'autre côté de la couche de propagation Cp est dopée n. Une autre couche métallique M2 est mise en contact avec la couche Cf2. La continuité électrique de la couche Cf2 permet d'injecter un courant entre M1 et M2.

Il est ainsi possible d'injecter un courant I dans la couche de propagation dans la zone localisée sous la couche métallique, ce qui a pour effet de modifier localement l'indice de réfraction en fonction de la valeur de I. Si aucun courant n'est appliqué, l'indice de réfraction que voit le signal optique O est le même dans les zones qui entourent $M_{ph}$ et à l'intérieur de Mph. Le faisceau O n'est alors pas dévié par $M_{ph}$. Si un courant I est appliqué, l'indice de réfraction que voit le signal optique O est différent dans les zones qui entourent $M_{ph}$ de celui à l'intérieur de Mph.

Le déflecteur $M_{ph}$ est ainsi un modulateur électro-optique configuré pour modifier l'indice de réfraction d'une portion de la couche de propagation Cp. Lorsque la portion présente une forme prismatique dans le plan XY, et pour un indice à l'intérieur de $M_{ph}$ dans la couche de propagation plus élevé qu'à l'extérieur, l'onde optique O, du fait des lois de Fresnel, est déviée de la même manière que dans le cas d'un prisme.

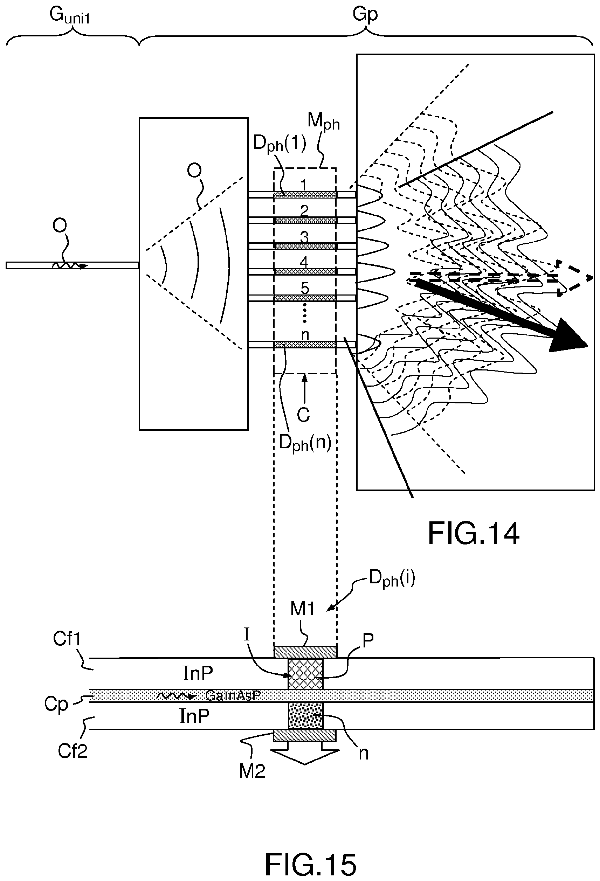

Selon un deuxième exemple le déflecteur est un modulateur de phase $M_{ph}$ comprenant une pluralité de i déphaseurs discrets $D_{ph}(1)$, .... $D_{ph}(n)$ commandés indépendamment. Le principe de ce déphaseur discret est illustré figure 14 pour une onde optique O.

L'onde optique, propagée dans une première zone de propagation « libre » du guide planaire, est répartie sur n canaux. Un déphaseur optique Dph(i) par canal fait varier le déphasage optique du canal i indépendamment des autres canaux. Les ondes issues des canaux se propagent ensuite dans une deuxième zone de propagation « libre » dans le guide planaire Gp. Dans cette deuxième zone un front d'onde se forme dont la direction dépend des déphasages appliqués au moyen des déphaseurs. On contrôle donc via le déphaseur le front de phase de l'onde optique. Pour une loi de phase déterminée, une déviation globale du front d'onde par rapport au front d'onde incident est obtenue.

Le déphaseur fonctionne par exemple de manière électro-optique, c'est-à-dire qu'un signal de commande électrique vient modifier l'indice de réfraction dans un canal comprenant par exemple une portion de la couche de propagation.

Un déphaseur électro-optique Dph(i) est illustré figure 15 pour un guide planaire comprenant une couche de propagation Cp en GalnAsP et deux couches de confinements Cf1 Cf2 en InP. Il fonctionne de la même manière que le déphaseur de la figure 13b. Une couche métallique M1 est disposée sur la couche Cf1. Une zone de la couche Cf1 sous la couche métallique M est dopée p tandis que la zone de la couche Cf2 de l'autre côté de la couche de propagation Cp est dopée n. Une autre couche métallique M2 est mise en contact avec la couche Cf2. La continuité électrique de la couche Cf2 permet d'injecter un courant entre M1 et M2. L'injection d'un courant I dans la couche de propagation a pour effet de modifier localement l'indice de réfraction en fonction de la valeur de I.

Il est bien entendu possible d'intégrer, en plus du déflecteur, des amplificateurs optiques alimentés électriquement afin de modifier la puissance optique.

Les amplificateurs optiques sont par exemple positionnés dans chaque canal, permettant ainsi d'uniformiser la puissance optique entre les différents canaux.

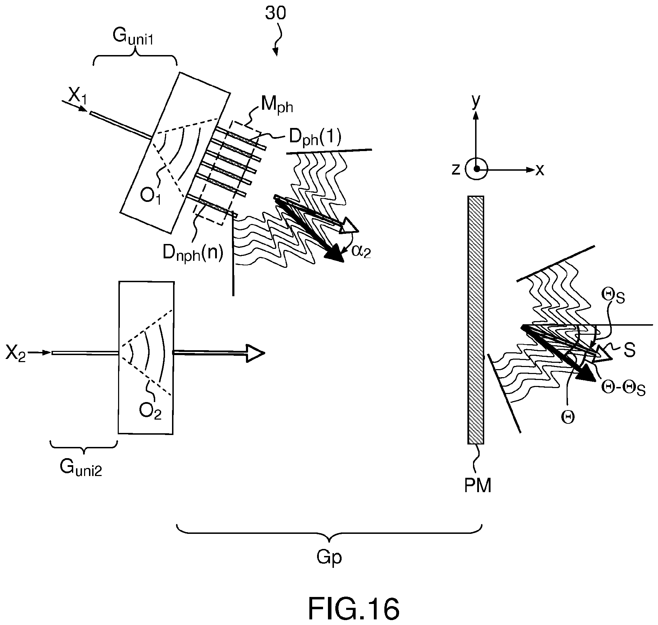

La figure 16 illustre un composant selon l'invention dont le guide planaire Gp comprend un modulateur de phase $M_{Ph}$ électro-optique tel que décrit ci-dessus sur le chemin optique de l'onde présentant un angle Theta1 non nul , O1 ici.

Le signal S rayonné par le photo-mélangeur PM est apte à être dévié (c'est-à-dire la direction de pointage correspondant du maximum d'énergie rayonnée) selon un angle de déviation θ fonction de theta1, theta2 et α2. La déviation par rapport à l'angle initial θs est (θ - θs).

Ainsi le caractère intégré du composant 30 selon l'invention permet de profiter de l'allongement du photo-mélangeur PM pour faciliter l'implémentation de fonctions d'amplification et de balayage, formant un circuit intégré photonique réalisant un balayage angulaire d'un signal S haute fréquence F.

## Revendications

1.  Composant optoélectronique (30) pour générer et rayonner un signal (S) électromagnétique présentant une fréquence (F) comprise entre 30 GHz et 10 THz dénommée fréquence hyper, comprenant :

    - un guide planaire (Gp) configuré pour confiner et propager librement dans un plan XY une première (O1) et une deuxième (O2) ondes optiques présentant une différence de fréquence optique, dénommée battement hétérodyne, égale à ladite fréquence hyper (F),
    - un système d'injection (Si) desdites ondes optiques (O1, O2) dans ledit guide planaire (Gp),
    - un photo-mélangeur (PM) couplé audit guide planaire (Gp) de manière à générer, à partir de la première onde optique (O1) et de la deuxième onde optique (O2), un signal (S) présentant ladite fréquence hyper (F),

    **caractérisé en ce que**
    ledit photo-mélangeur (PM) a une forme allongée présentant selon un axe Y une grande dimension (L) supérieure ou égale à la demi longueur d'onde ($\lambda_F$) dudit signal (S),

    - ledit système d'injection (Si) est configuré de sorte que lesdites ondes optiques se recouvrent dans ledit guide planaire et se couplent au photo-mélangeur (PM) sur une longueur selon l'axe Y au moins égale à la demi longueur d'onde ($\lambda_F$) dudit signal (S), le photo-mélangeur étant ainsi apte à rayonner ledit signal (S).

2.  Composant optoélectronique selon la revendication 1 dans lequel ledit guide planaire (Gp) comprend une couche de propagation (Cp) entre deux couches de confinement (Cf1, Cf2).

3.  Composant optoélectonique selon la revendication 2 dans lequel le photo-mélangeur (PM) est déposé sur une couche de confinement et dans lequel ledit couplage s'effectue par ondes évanescentes.

4. Composant optoélectronique selon l'une des revendications précédentes dans lequel le guide planaire (Gp) est configuré pour confiner des ondes optiques présentant chacune une longueur d'onde proche de 1.5 $\mu$m.

5. Composant optoélectronique selon l'une des revendications précédentes dans lequel ledit guide planaire (Gp) comprend une partie amplificatrice (CA) apte à amplifier lesdites première (O1) et deuxième (O2) ondes optique.

6. Composant optoélectronique selon l'une des revendications précédentes dans lequel le système d'injection (Si) est configuré pour que les ondes optiques (O1, O2) injectées présentent une forte divergence.

7. Composant optoélectronique selon l'une des revendications précédentes dans lequel ledit système d'injection (Si) comprend au moins un guide dit monodimensionnel (Guni0, Guni1, Guni2) configuré pour confiner les ondes optiques (O1, O2) de manière à ce que lesdites ondes se propagent selon leurs directions de propagation respectives (X, X1, X2).

8. Composant optoélectronique selon la revendication 7 dans lequel le guide monodimensionnel est constitué d'un prolongement du guide planaire comprenant une couche de confinement en forme de ruban.

9. Composant optoélectronique selon l'une des revendications 1 à 6 dans lequel le système d'injection (Si) comprend au moins une fibre optique.

10. Composant optoélectronique selon l'une des revendications précédentes dans lequel le système d'injection (Si) comprend un dispositif d'injection unique (Di0).

11. Composant optoélectronique selon la revendication 10 dans lequel ledit dispositif d'injection unique (Di0)est configuré pour injecter les première et deuxième ondes optiques (O1, O2) de manière à ce que lesdites ondes se propagent selon une direction de propagation sensiblement égale à une direction X perpendiculaire à l'axe Y.

12. Composant optoélectronique selon l'une des revendications 1 à 9 dans lequel ledit système d'injection (Si) comprend un premier dispositif d'injection (Di1) configuré pour injecter la première onde optique (O1) de manière à ce que ladite première onde se propage selon une première direction de propagation (X1) comprise dans le plan XY, et un deuxième dispositif d'injection (Di2) configuré pour injecter la deuxième onde optique (O2) de manière à ce que ladite deuxième onde se propage selon une deuxième direction de propagation (X2) comprise dans le plan XY différente de la première direction de propagation (X1).

13. Composant optoélectronique selon la revendication 12 dans lequel un seul desdits premier et deuxième dispositifs d'injections (Di1,Di2) présente une direction de propagation perpendiculaire audit axe Y.

14. Composant optoélectronique selon les revendications 12 ou 13 dans lequel le guide planaire (Gp) comprend en outre au moins un déflecteur ($M_{Ph}$) situé sur le chemin optique d'une des ondes optiques (O2) configuré pour défléchir ladite onde optique (O2) de manière à la dévier d'un angle ($\alpha 2$) de déviation optique choisi, moyennant quoi le signal (S) rayonné par ledit photo-mélangeur (PM) est apte à être dévié selon un angle de déviation ($\theta$-$\theta$s) fonction dudit angle de déviation optique ($\alpha 2$).

15. Composant optoélectronique selon la revendication 14 dans lequel ledit déflecteur ($M_{ph}$) est un modulateur électro-optique configuré pour modifier l'indice de réfraction d'une portion de la couche de propagation (Cp), ladite portion présentant une forme prismatique dans le plan XY.

16. Composant optoélectronique selon l'une des revendications 14 ou 15 dans lequel ledit déflecteur est un modulateur de phase ($M_{ph}$) comprenant une pluralité de déphaseurs discrets ($D_{ph}(1)$, .... $D_{ph}(n)$) commandés indépendamment.

17. Composant optoélectronique selon la revendication 16 dans lequel chaque déphaseur discret est un modulateur électro-optique configuré pour modifier l'indice de réfraction d'une portion de la couche de propagation (Cp).

**Patentansprüche**

1. Optoelektronisches Bauelement (30) zum Erzeugen und Abstrahlen eines elektromagnetischen Signals (S), welches eine Frequenz (F) aufweist, welche zwischen 30 GHz und 10 THz liegt, genannt Mikrowellenfrequenz, welches Folgendes beinhaltet:

   - eine planare Führung (Gp), welche konfiguriert ist, um eine erste (O1) und eine zweite (O2) optische Welle einzuschließen und frei zu propagieren in einer Ebene XY, wobei die Wellen eine Differenz in Bezug auf die optische Frequenz aufweisen, genannt Überlagerungs schwebung, welche der Mikrowellenfrequenz (F) entspricht,
   - ein System zur Injektion (Si) der optischen Wellen (O1, O2) in die planare Führung (Gp),
   - einen Photomischer (PM), welcher mit der planaren Führung (Gp) in der Weise gekoppelt ist, dass anhand der ersten optischen Welle (O1) und der zweiten optischen Welle (O2) ein Signal (S) erzeugt wird, das die Mikrowellenfrequenz (F) aufweist,

   **dadurch gekennzeichnet, dass**
   der Photomischer (PM) eine längliche Form besitzt, welche entlang einer Y-Achse eine große Abmessung (L) besitzt, welche größer ist als die oder gleich der halben Wellenlänge ($\lambda_F$) des Signals (S) ist,

   - wobei das Injektionssystem (Si) so konfiguriert ist, dass die optischen Wellen einander in der planaren Führung überlagern und sich mit dem Photomischer (PM) über eine Länge entlang der Y-Achse koppeln, welche mindestens gleich der halben Wellenlänge ($\lambda_F$) des Signals (S) ist, wobei der Photomischer so in der Lage ist, das Signal (S) abzustrahlen.

2. Optoelektronisches Bauelement nach Anspruch 1, bei welchem die planare Führung (Gp) eine Propagationsschicht (Cp) zwischen zwei Einschließungsschichten (Cf1, Cf2) beinhaltet.

3. Optoelektronisches Bauelement nach Anspruch 2, bei welchem der Photomischer (PM) auf einer Einschließungsschicht abgelagert ist, und bei welchem die Kopplung durch evaneszente Wellen erfolgt.

4. Optoelektronisches Bauelement nach einem der vorhergehenden Ansprüche, bei welchem die planare Führung (Gp) konfiguriert ist, um optische Wellen, welche jeweils eine Wellenlänge nahe von 1,5 $\mu$m aufweisen, einzuschließen.

5. Optoelektronisches Bauelement nach einem der vorhergehenden Ansprüche, bei welchem die planare Führung (Gp) einen Verstärkungsabschnitt (CA) besitzt, welches in der Lage ist, die erste (O1) und die zweite (O2) optische Welle zu verstärken.

6. Optoelektronisches Bauelement nach einem der vorhergehenden Ansprüche, bei welchem das Injektionssystem (Si) so konfiguriert ist, dass die injizierten optischen Wellen (O1, O2) eine starke Abweichung aufweisen.

7. Optoelektronisches Bauelement nach einem der vorhergehenden Ansprüche, bei welchem das Injektionssystem (Si) mindestens eine monodimensional genannte Führung (GuniO, Guni1, Guni2) beinhaltet, welche konfiguriert ist, um die optischen Wellen (O1, O2) so einzuschließen, dass die Wellen sich entlang ihrer jeweiligen Propagationsrichtungen (X, X1, X2) fortpflanzen.

8. Optoelektronisches Bauelement nach Anspruch 7, bei welchem die monodimensionale Führung aus einer Verlängerung der planaren Führung besteht, welche eine bandförmige Einschließungsschicht beinhaltet.

9. Optoelektronisches Bauelement nach einem der Ansprüche 1 bis 6, bei welchem das Injektionssystem (Si) mindestens eine optische Faser beinhaltet.

10. Optoelektronisches Bauelement nach einem der vorhergehenden Ansprüche, bei welchem das Injektionssystem (Si) eine einzige Injektionsvorrichtung (Di0) beinhaltet.

11. Optoelektronisches Bauelement nach Anspruch 10, bei welchem die einzige Injektionsvorrichtung (Di0) konfiguriert ist, um die erste und die zweite optische Welle (O1, O2) so zu injizieren, dass die Wellen sich entlang einer Propagationsrichtung fortpflanzen, welche im Wesentlichen einer X-Richtung entspricht, welche rechtwinklig zur Y-Achse ist.

12. Optoelektronisches Bauelement nach einem der Ansprüche 1 bis 9, bei welchem das Injektionssystem (Si) eine erste Injektionsvorrichtung (Di1) beinhaltet, welche konfiguriert ist, um die erste optische Welle (O1) so zu injizieren, dass die erste Welle sich entlang einer ersten Propagationsrichtung (X1) fortpflanzt, welche in der Ebene XY enthalten ist, und eine zweite Injektionsvorrichtung (Di2) beinhaltet, welche konfiguriert ist, um die zweite optische Welle (O2) so zu injizieren, dass die zweite Welle sich entlang einer zweiten Propagationsrichtung (X2) fortpflanzt, welche in der Ebene XY enthalten ist und sich von der ersten Propagationsrichtung (X1) unterscheidet.

13. Optoelektronisches Bauelement nach Anspruch 12, bei welchem eine einzige der ersten und der zweiten Injektionsvorrichtung (Di1, Di2) eine Propagationsrichtung aufweist, welche rechtwinklig zur Y-Achse ist.

14. Optoelektronisches Bauelement nach einem der Ansprüche 12 oder 13, bei welchem die planare Führung (Gp) zudem mindestens einen Deflektor ($M_{Ph}$) beinhaltet, welcher im optischen Weg einer der optischen Wellen (O2) befindlich und konfiguriert ist, um die optische Welle (O2) so abzulenken, dass sie um einen gewählten optischen Ablenkwinkel ($\alpha2$) abgelenkt wird,
wodurch das Signal (S), welches vom Photomischer (PM) ausgestrahlt wird, in der Lage ist, um einen Ablenkwinkel ($\theta-\theta s$) abgelenkt zu werden, welcher vom optischen Ablenkwinkel ($\alpha2$) abhängt.

15. Optoelektronisches Bauelement nach Anspruch 14, bei welchem der Deflektor ($M_{Ph}$) ein elektrooptischer Modulator ist, welcher konfiguriert ist, um den Brechungsindex eines Abschnittes der Propagationsschicht (Cp) zu ändern, wobei der Abschnitt eine Prismenform in der Ebene XY besitzt.

16. Optoelektronisches Bauelement nach einem der Ansprüche 14 oder 15, bei welchem der Deflektor ein Phasenmodulator (Mph) ist, welcher eine Vielzahl von diskreten Phasenschiebern ($D_{ph}(1)$, ....$D_{ph}(n)$) beinhaltet, welche unabhängig voneinander gesteuert werden.

17. Optoelektronisches Bauelement nach Anspruch 16, bei welchem jeder diskrete Phasenschieber ein elektrooptischer Modulator ist, welcher konfiguriert ist, um den Brechungsindex eines Abschnitts der Propagationsschicht (Cp) zu ändern.

**Claims**

1. An optoelectronic component (30) for generating and radiating an electromagnetic signal (S) exhibiting a frequency (F) lying between 30 GHz and 10 THz referred to as a microwave frequency, comprising:

   - a planar guide (Gp) configured to confine and propagate freely in a plane XY a first (O1) and a second (O2) optical wave exhibiting an optical frequency difference, referred to as a heterodyne beat, equal to said microwave frequency (F),
   - a system (Si) for injecting said optical waves (O1, O2) into said planar guide (Gp),
   - a photo-mixer (PM) coupled to said planar guide (Gp) so as to generate, on the basis of the first optical wave (O1) and of the second optical wave (O2), a signal (S) exhibiting said microwave frequency (F),

   **characterized in that**
   said photo-mixer (PM) has an elongated shape exhibiting along an axis Y a large dimension (L) greater than or equal to half the wavelength ($\lambda_F$) of said signal (S),

   - said injection system (Si) is configured so that said optical waves overlap in said planar guide and are coupled with the photo-mixer (PM) over a length along the axis Y at least equal to half the wavelength ($\lambda_F$) of said signal (S), the photo-mixer thus being able to radiate said signal (S).

2. The optoelectronic component according to claim 1, in which said planar guide (Gp) comprises a propagation layer (Cp) between two confinement layers (Cf1, Cf2).

3. The optoelectronic component according to claim 2, in which the photo-mixer (PM) is deposited on a confinement layer and in which said coupling is performed by evanescent waves.

4. The optoelectronic component according to one of the preceding claims, in which the planar guide (Gp) is configured to confine optical waves each exhibiting a wavelength of close to 1.5 $\mu$m.

5. The optoelectronic component according to one of the preceding claims, in which said planar guide (Gp) comprises an amplifying part (CA) able to amplify said first (O1) and second (O2) optical waves.

6. The optoelectronic component according to one of the preceding claims, in which the injection system (Si) is configured so that the injected optical waves (O1, O2) exhibit strong divergence.

7. The optoelectronic component according to one of the preceding claims, in which said injection system (Si) comprises at least one so-called monodimensional guide (GuniO, Guni1, Guni2) configured to confine the optical waves (O1, O2) in such a way that said waves propagate along their respective directions of propagation (X, X1, X2).

8. The optoelectronic component according to claim 7, in which the monodimensional guide consists of a prolongation of the planar guide comprising a strip-shaped confinement layer.

9. The optoelectronic component according to one of claims 1 to 6, in which the injection system (Si) comprises at least one optical fiber.

10. The optoelectronic component according to one of the preceding claims, in which the injection system (Si) comprises a single injection device (Di0).

11. The optoelectronic component according to claim 10, in which said single injection device (Di0) is configured to inject the first and second optical waves (O1, O2) in such a way that said waves propagate along a direction of propagation substantially equal to a direction X perpendicular to the axis Y.

12. The optoelectronic component according to one of claims 1 to 9, in which said injection system (Si) comprises a first injection device (Di1) configured to inject the first optical wave (O1) in such a way that said first wave propagates along a first direction of propagation (X1) lying in the plane XY, and a second injection device (Di2) configured to inject the second optical wave (O2) in such a way that said second wave propagates along a second direction of propagation (X2) lying in the plane XY and different from the first direction of propagation (X1).

13. The optoelectronic component according to claim 12, in which a single one of said first and second injection devices (Di1,Di2) exhibits a direction of propagation perpendicular to said axis Y.

14. The optoelectronic component as claimed in claim 12 or 13, in which the planar guide (Gp) furthermore comprises at least one deflector ($M_{Ph}$) situated on the optical path of one of the optical waves (O2) and configured to deflect said optical wave (O2) in such a way as to deviate it by a chosen angle ($\alpha$2) of optical deviation, whereby the signal (S) radiated by said photo-mixer (PM) is able to be deviated according to an angle of deviation ($\theta$-$\theta$s) dependent on said angle of optical deviation ($\alpha$2).

15. The optoelectronic component according to claim 14, in which said deflector ($M_{ph}$) is an electro-optical modulator configured to modify the refractive index of a portion of the propagation layer (Cp), said portion exhibiting a prismatic shape in the plane XY.

16. The optoelectronic component according to one of claims 14 or 15, in which said deflector is a phase modulator ($M_{ph}$) comprising a plurality of independently controlled discrete phase-shifters ($D_{ph}(1)$, .... $D_{ph}(n)$).

17. The optoelectronic component according to claim 16, in which each discrete phase-shifter is an electro-optical modulator configured to modify the refractive index of a portion of the propagation layer (Cp).

$100$

$\ell_{10}$

$12$

$11$

$10$

$O_1, \lambda_1$
$O_2, \lambda_2$

$L_{10}$

$S, F = f_1 - f_2$
$f_1 = \dfrac{c}{\lambda_1}$
$f_2 = \dfrac{c}{\lambda_2}$

FIG.1a

$100$

$12$

$O_1, \lambda_1$
$O_2, \lambda_2$

$11$

$10$

FIG.1b

FIG.2

30

$S_i$

$O_1$

$O_2$

$O_1$   $O_2$

$S, [F ; \lambda_F = \dfrac{C}{F}]$

$F = f_1 - f_2$

$f_1 = \dfrac{c}{\lambda_1}$

$f_2 = \dfrac{c}{\lambda_2}$

$L \geq \dfrac{\lambda_F}{2}$

$\ell$

PM

Gp

## FIG.3a

$O_1$   $O_2$

$S, [F , \lambda_F]$

## FIG.3b

FIG.4

30

Gp

$S_i$

$O_1$

$O_1$

$O_2$

$O_2$

PM

CA

Cf

Cp

Cf

## FIG.5

Gp

GaInAsP

CA

Cf

InP

InP

InP

Cp

GaInAsP

InP

InP

InP

Cf

QW - GaInAsP

## FIG.6

FIG.7a

FIG.7b

FIG.8

FIG.9a

FIG.9b

FIG.10

FIG.11

FIG.12

FIG.13a

FIG.13b

FIG.14

FIG.15

FIG.16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **STOEHR et al.** Optical heterodyne millimeter-wave genenration using 1.55 μm travelig-wave photodetectors. *IEE Transactions on microwave theory and techniques,* 2001, vol. 49 (10), 1926-1933

- **ROUVALIS et al.** High speed photodiodes for InP-based photonic integrated circuits. *Optic Express,* 2012, vol. 20 (8), 9170